# EUROPEAN PATENT APPLICATION

(11) **EP 4 043 889 A1**
(43) Date of publication of application: **17.08.2022**
(21) Application number: 22155241.7
(22) Date of filing: 04.02.2022
(51) Int. Cl.: G01R 15/18, G01R 15/20

(54) **CURRENT DETECTOR**

(30) Priority: 12.02.2021 JP 2021021335
(71) Applicant: Toyo System Co., Ltd., Iwaki-shi, Fukushima 972-8316 (JP)
(72) Inventor: Shoji, Masahiro, Fukushima (JP); Aoki, Ryota, Fukushima (JP); Shoji, Hideki, Fukushima (JP)
(74) Representative: Dr. Schoen, Neymeyr & Partner Patentanwälte mbB

(57) **Abstract**

Provided is a current detector capable of easily increasing the current measurement accuracy even if the winding thickness of the coil winding wire is not uniform. The current detector (1) is a magnetic balance type current detector with a ring-shaped coil (10) fixed in an outer case (30). The coil contains a magnetic core (101) and a ring-shaped core housing case (103) that houses the magnetic core. The outer case has an insertion hole (301) inside, through which a conductor (90) is inserted, and has a coil housing space (303). The core housing case has a first protrusion (111) and a second protrusion (113) that abuts on an inner wall surface of the coil housing space to form a gap (Ga) between the inner wall surface and the coil and that positions the magnetic core and the conductor attached to the insertion hole of the outer case orthogonally to each other.

## Description

### BACKGROUND OF THE INVENTION

### 1. Field of the Invention

The present invention relates to a magnetic balance type current detector.

### 2. Description of the Related Art

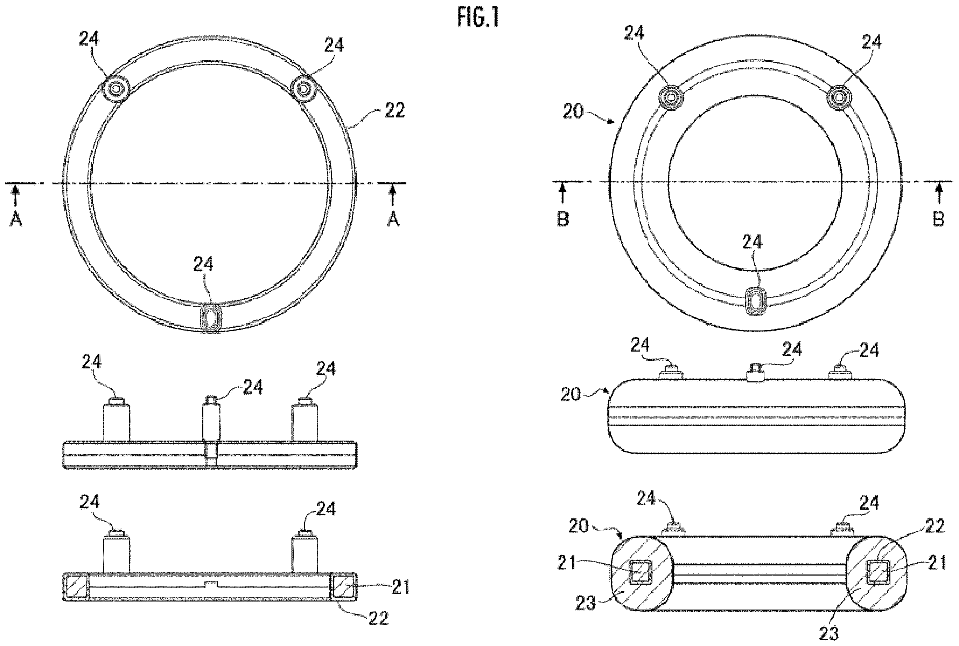

Conventionally, there has been known a magnetic balance type current detector with a coil as illustrated on the right in FIG. 1.

### Problems to be solved by the invention

A coil 20 used in the magnetic balance type current detector has a structure, as illustrated on the right of FIG. 1, in which a winding wire 23 is wound around the outside of a housing case 22 that encloses a magnetic core 21 as illustrated on the left of FIG. 1 by sandwiching the magnetic core 21 from above and below, where the winding wire 23 carries a feedback current to always set the magnetism detected by a Hall element, which is a magnetic sensing element, to zero.

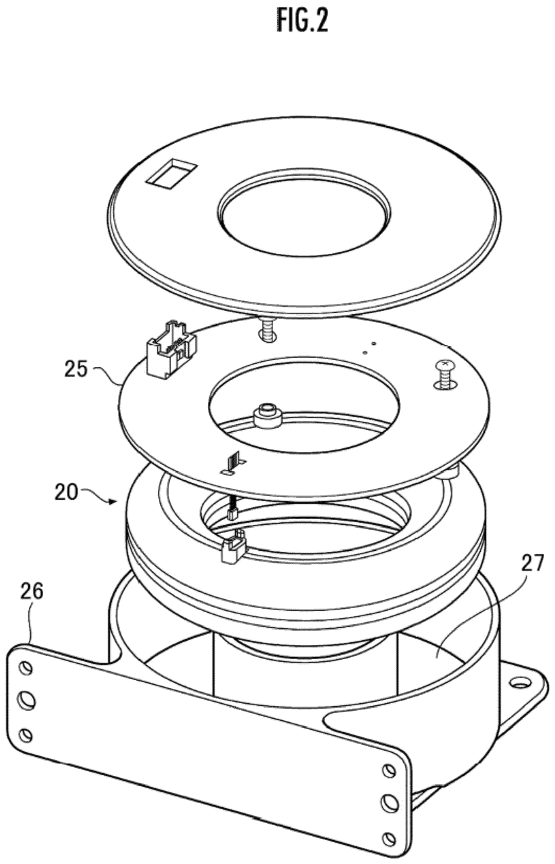

Additionally, the housing case 22 is provided with a plurality of protrusions 24 on its upper surface, and these protrusions 24 are used to fix a substrate 25, on which the Hall element is mounted, and the coil 20 (see FIG. 2).

FIG. 2 is an exploded view of a conventional magnetic balance type current detector. In a general structure, as illustrated in FIG. 2, the coil 20 used in the magnetic balance type current detector is fitted into the outer case 26 for positioning with respect to the conductor through which the current to be measured flows while ensuring the insulation of the coil 20, with the coil 20 lying down and its lower surface in contact with the inner wall 27 of the outer case 26, and is then fixed in the outer case 26 by filling the outer case 26 with molding material so that the coil 20 does not move inside the outer case 26.

In this case, if the coil 20 is fixed in a tilted position with respect to the outer case 26, the measurement accuracy of the current flowing through the conductor is degraded. Therefore, it is necessary to prevent the coil 20 from being fixed in the tilted position with respect to the outer case 26. If the winding thickness of the winding wire 23 is not uniform, however, the surface of the coil 20 will be uneven. Therefore, it is difficult to fix the coil 20 in the outer case 26 without tilting, since the coil 20 is fitted into the outer case 26 with its surface in contact with the inner wall 27 of the outer case 26.

It is possible to reduce the non-uniformity of the winding thickness as much as possible by slowing down the winding speed during winding processing, but it increases the processing cost accordingly and further it is very difficult to completely eliminate the non-uniformity of the winding thickness. There is a need for a technique capable of solving these problems.

In conventional current detectors such as those illustrated in FIGS. 1 and 2, however, this point is not taken into consideration. Therefore, if there is non-uniformity in the winding thickness of the winding wire 23, the magnetic core 21 may be fixed in a tilted position with respect to the outer case 26, and as a result, the current measurement accuracy cannot be prevented from decreasing.

### SUMMARY OF THE INVENTION

Therefore, an object of the present invention is to provide a current detector capable of easily increasing the current measurement accuracy even if the winding thickness of the winding wire of the coil is non-uniform.

### Means to solve the problem

A current detector according to the present invention is a magnetic balance type current detector with a ring-shaped coil fixed in an outer case, wherein: the coil includes: a ring-shaped magnetic core that converges a magnetic flux generated by a current flowing through a conductor to be measured; a ring-shaped core housing case that houses the magnetic core; and a conductive winding wire that is wrapped around the core housing case to form the ring-shaped coil; the outer case has an insertion hole formed inside, through which the conductor is inserted, and has a coil housing space that is a ring-shaped space that surrounds the insertion hole and houses the coil; the current detector has a substrate with a magnetic flux sensing element mounted thereon, the magnetic flux sensing element sensing the magnetic flux converted on the magnetic core; the core housing case being arranged between the substrate and an inner wall surface of the coil housing space of the outer case, and the core housing case is provided with: a first protrusion which is a protrusion protruding toward the substrate from an outer surface of the core housing case and fixing the core housing case to the substrate; a second protrusion which is a plurality of protrusions that protrudes in an opposite direction of the first protrusion from the outer surface of the core housing case, abutting on the inner wall surface of the coil housing space to support the core housing case with respect to the outer case; wherein a protrusion height of each of the plurality of second protrusions is a height which forms a gap between the inner wall surface and the coil, and positioning a ring formed by the magnetic core housed in the core housing case and the conductor attached to the insertion hole of the outer case orthogonally to each other, when an end portion of each of the plurality of second protrusions abuts on the inner wall surface of the coil housing space.

According to the present invention, the current detector is positioned with respect to the conductor whose current is to be measured by the insertion hole of the outer case.

Then, the second protrusions provided on the core housing case, the second protrusions protruding in the opposite direction of the first protrusion, having a height so as to position the ring formed by the magnetic core housed in the core housing case and the conductor attached to the insertion hole of the outer case orthogonally to each other.

In addition, since a gap is formed between the coil and the inner wall surface, the surface of the coil does not touch the inner wall surface even if the surface of the coil is uneven due to a non-uniform winding thickness of the winding wire of the coil, thereby preventing the coil from being fixed in a tilted position with respect to the outer case.

This makes it easy to increase the current measurement accuracy even if the winding thickness of the winding wire is not uniform.

In the current detector according to the present invention, preferably the outer case has a movement restriction part at a portion where the second protrusion abuts, so as to restrict a rotation of the coil around the conductor and a movement of the coil toward or away from the conductor.

If the coil moves in the coil housing space, the coil is misaligned with respect to the conductor in their positional relationship and the current measurement accuracy is degraded.

According to the present invention, the movement restriction part of the outer case of the current detector, the movement restriction part being provided at the portion which each of the plurality of second protrusions abuts, restricts the rotation of the coil around the conductor in the coil housing space and the movement of the coil toward or away from the conductor, and therefore the positional relationship with the conductor is able to be easily kept constant.

This prevents a decrease in the current measurement accuracy due to misalignment with the conductor.

### BRIEF DESCRIPTION OF THE DRAWINGS

FIG. 1 is a diagram illustrating an example of the coil structure and core housing case structure used for a conventional current detector.
FIG. 2 is a diagram illustrating the structure of the conventional current detector.
FIG. 3 is a diagram illustrating an example of the structure of a current detector of the present invention.
FIG. 4 is a diagram illustrating an example of the structure of a coil used for the current detector of the present invention.
FIG. 5 is a diagram illustrating an example of the structure of a core housing case used for the current detector of the present invention.
FIG. 6 is a diagram illustrating the usage state of the current detector of the present invention.
FIG. 7 is a diagram illustrating modification examples of the core housing case used in the current detector of the present invention.

### DESCRIPTION OF THE PREFERRED EMBODIMENTS

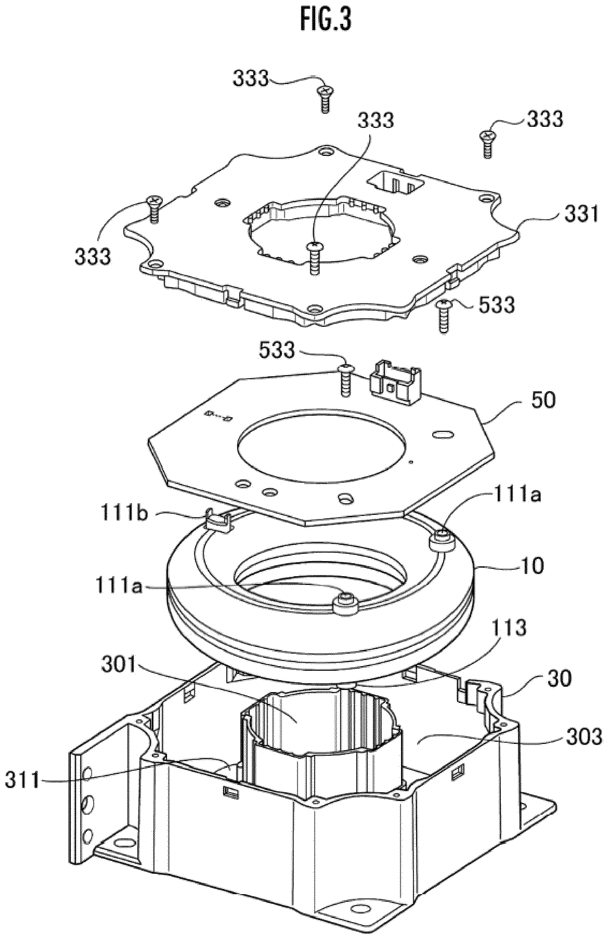

The current detector of this embodiment will be described with reference to FIGS. 3 to 6. The same components are denoted by the same reference numerals, and the description of the components will be omitted in some cases.

First, the overall configuration of a current detector 1 of the present embodiment will be described. FIG. 3 is an exploded view of the current detector 1 of the present embodiment.

As illustrated in FIG. 3, the current detector 1 of this embodiment is a magnetic balance type current detector including a ring-shaped coil 10, an outer case 30 that houses and fixes the coil 10, and a substrate 50 fixed to the coil 10.

Although the coil 10 is annular in this embodiment, the term "ring-shaped" is not limited to the annular shape, and, for example, a coil having a polygonal ring shape such as a square ring may be used as long as the function of a coil for a current detector is not impaired. The same applies to the shapes of a ring-shaped magnetic core 101, a ring-shaped core housing case 103, and a coil housing space 303, which will be described later.

As illustrated in FIG. 3, the outer case 30 has an insertion hole 301, which is formed inside to position the current detector 1 with respect to a conductor with the conductor inserted through the insertion hole 301, and has a coil housing space 303, which is a ring-shaped space surrounding the insertion hole 301 and houses the coil 10.

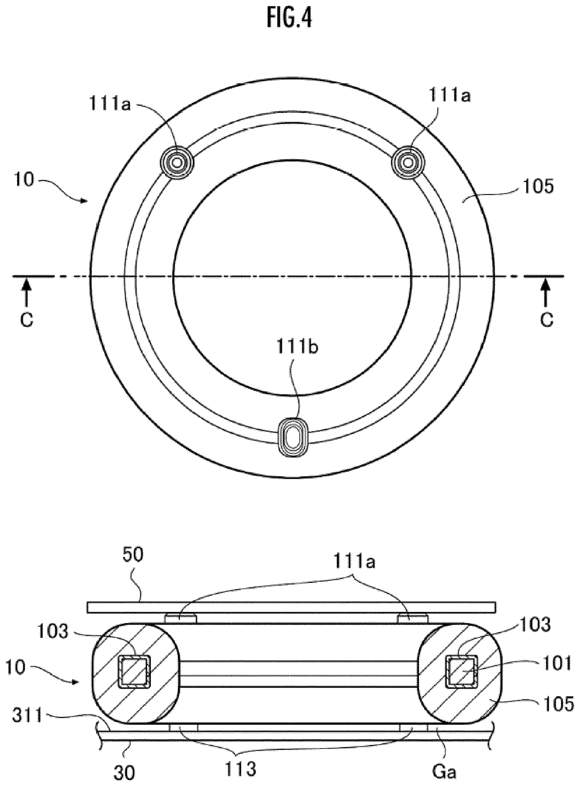

The upper figure in FIG. 4 illustrates the coil 10 of this embodiment viewed from the direction where the substrate 50 is fixed, and the lower figure in FIG. 4 is a cross-sectional view of the coil 10 of this embodiment.

As illustrated in FIG. 4, the coil 10 includes a ring-shaped magnetic core 101 for converging a magnetic flux generated by a current flowing through a conductor to be measured, a ring-shaped core housing case 103 for housing the magnetic core 101, and a conductive winding wire 105, which is wound around the core housing case 103 to form the ring-shaped coil 10.

The core housing case 103 is arranged between the substrate 50 and an inner wall surface 311 of the coil housing space of the outer case 30, A plurality of first protrusions 111 (111a, 111b) of the core housing case 103 protrudes from the surface of the coil 10 on the substrate 50 side, and a plurality of second protrusions 113 of the core housing case 103 protrudes from the surface of the coil 10 on the opposite side.

As the material of the magnetic core 101, for example, a material such as silicon steel, permalloy, ferrite, or an amorphous alloy may be appropriately used. In addition, the magnetic core 101 has an air gap in which a magnetic flux sensing element 501, which will be described later, is placed. The air gap only need to have sufficient depth, width, and the like for placing the magnetic flux sensing element 501. In other words, for example, the magnetic core 101 has a gap portion that is C-shaped when viewed from the substrate 50 side, and the gap portion may form the air gap. Alternatively, for example, the air gap may be formed by a slit that does not penetrate the magnetic core 101.

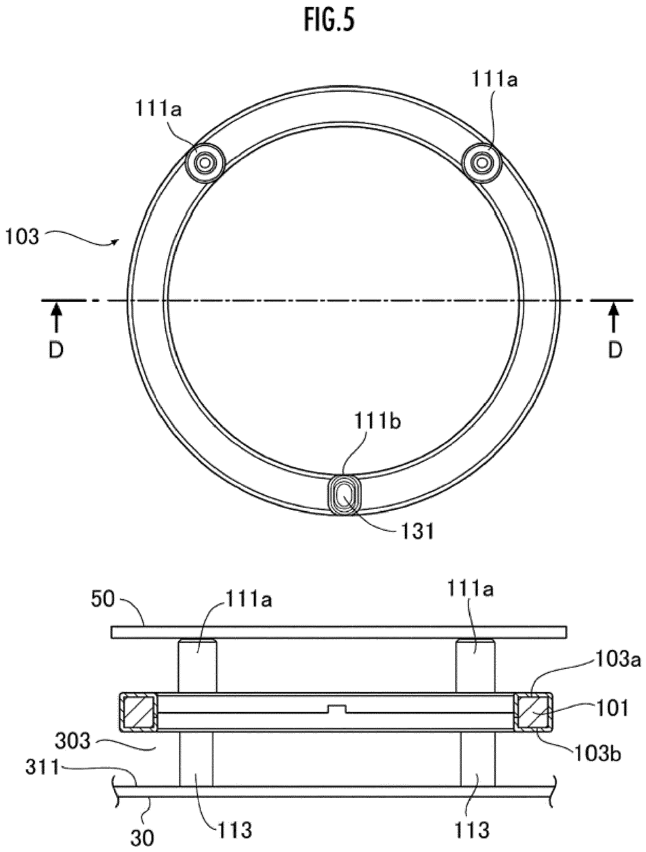

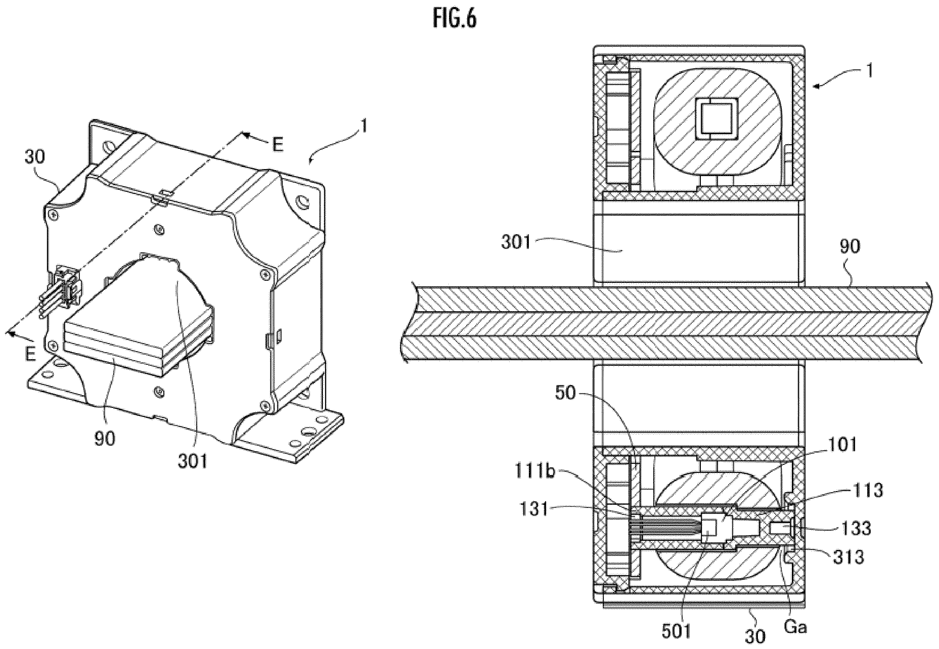

The upper figure in FIG. 5 illustrates the core housing case 103 of this embodiment viewed from the direction where the substrate 50 is fixed, and the lower figure in FIG. 5 is a cross-sectional view of the core housing case 103 of this embodiment. The left figure in FIG. 6 is a perspective view illustrating the usage state of the current detector 1 of this embodiment, and the right figure in FIG. 6 is a cross-sectional view illustrating the usage state of the current detector 1 of this embodiment.

As illustrated in FIG. 5, the core housing case 103 has first protrusions (111a, 111b), which are a plurality of protrusions that protrudes in the direction of the substrate 50 (upper side in the figure) from the outer surface of the core housing case 103, fixing the core housing case 103 to the substrate 50, and second protrusions 113, which are a plurality of protrusions that protrudes on the opposite side (lower side in the figure) of the direction in which the first protrusions 111 protrude from the outer surface of the core housing case 103, abutting on the inner wall surface 311 of the coil housing space 303 to support the core housing case 103 with respect to the outer case 30. The protrusion height of each of the plurality of second protrusions 113 is a height which forms a gap Ga between the inner wall surface 311 and the coil 10 (see FIG. 4), and positioning a ring formed by the magnetic core 101 housed in the core housing case 103 and the conductor 90 attached to the insertion hole 301 of the outer case 30 orthogonally to each other (see FIG. 6), when an end portion of each of the plurality of second protrusions 113 abuts on the inner wall surface 311 of the coil housing space 303.

Subsequently, the details of the current detector 1 of this embodiment will be described. As illustrated in FIG. 3, the substrate 50 is fixed to the first protrusion 111 (111a, 111b) of the ring-shaped coil 10 by a substrate fixing screw 533. In addition, an outer case lid 331 is further placed on the outside (upper side in the figure) of the substrate 50 and is fixed to the outer case 30 by an outer case fixing screw 333.

The inner wall surface 311 of the outer case 30, on which each of the second protrusions 113 abuts, forms a plane orthogonal to the conductor 90. Therefore, positioning the magnetic core 101 so as to be parallel to the plane formed by the inner wall surface 311 causes the magnetic core 101 to be orthogonal to the conductor 90.

As illustrated in FIG. 5, the core housing case 103 is composed of, for example, a first member 103a on the side where the first protrusion 111 is provided and a second member 103b on the side where the second protrusion 113 is provided. The first member 103a and the second member 103b each have a groove for fitting the magnetic core 101, and the magnetic core 101 is fitted into the grooves in such a way that the first member 103a and the second member 103b sandwich the magnetic core 101 from the upper and lower sides in the lower figure in FIG. 5 to house the magnetic core 101.

Three first protrusions 111 are provided in this embodiment. A first protrusion 111b, one of the three, has an element insertion part 131 that guides the magnetic flux sensing element 501 mounted on the substrate 50 to the position of the air gap of the magnetic core 101.

The height of the first protrusion 111 (the vertical length in FIG. 5) is adjusted so that the surface of the winding wire 105 of the coil 10 on the substrate 50 side does not contact the substrate 50.

In this embodiment, three second protrusions 113 are provided at positions just opposite to the first protrusions 111, and the height of the second protrusion 113 (the vertical length in FIG. 5) is adjusted so that the surface of the winding wire 105 of the coil 10 on the inner wall surface 311 side does not contact the inner wall surface 311.

The substrate 50 is an electronic substrate on which the magnetic flux sensing element 501 for sensing a magnetic flux converged on the magnetic core 101 is mounted.

The magnetic flux sensing element 501 is, for example, a Hall element. The magnetic flux sensing element 501 is inserted from the opening of the element insertion part 131 provided on the substrate 50 side of the first protrusion 111b and is placed at the position of the air gap of the magnetic core 101.

In FIG. 6, for example, the conductor 90 is inserted through the insertion hole 301 of the outer case 30 in the lateral direction of the figure. Then, the second protrusion 113 positions the magnetic core 101 and the conductor 90 attached to the insertion hole 301 of the outer case 30 so as to be orthogonal to each other in the side view.

In addition, the outer case 30 may be provided with a movement restriction part 313, with the tip of each of the plurality of second protrusions 113 fitted into the portion which each of the plurality of second protrusions abuts, so as to restrict the rotation of the coil 10 around the conductor 90 in the outer case 30 and the movement of the coil 10 toward or away from the conductor 90 (the vertical direction and the depth direction in the right figure of FIG. 6).

In FIG. 6, a depression having a shape (circular in this embodiment) that matches the shape of the tip of the second protrusion 113 is provided as the movement restriction part 313 at the portion which the second protrusion 113 abuts. The tip of the second protrusion 113 is fitted into the depression to restrict the rotation of the coil 10 in the outer case 30 and the movement of the coil 10 toward or away from the conductor 90. In addition, the position of the movement restriction part 313 is adjusted to a position where the surface on the insertion hole 301 side of the coil 10 does not touch the inner wall surface on the insertion hole 301 side of the outer case 30 when the tip of the second protrusion 113 is fitted and where the surface on the outer peripheral side of the coil 10 does not touch the inner wall surface of the outer case 30.

Alternatively, for example, a depression 133 may be provided at the tip of the second protrusion 113, and a protrusion (not illustrated), which is adjusted in shape to fit the depression 133 and placed at a position in the inner wall surface 311 of the outer case 30 where the second protrusion 113 abuts, may fit into the depression 133. In this case, the protrusion (not illustrated) functions as the movement restriction part 313.

As described above, the present invention is able to provide a current detector capable of easily increasing the current measurement accuracy even if the winding thickness of the winding wire of the coil is non-uniform.

Although the embodiments of the present invention have been described above, the present invention is not limited thereto. Various modifications can be made without departing from the spirit of the present invention.

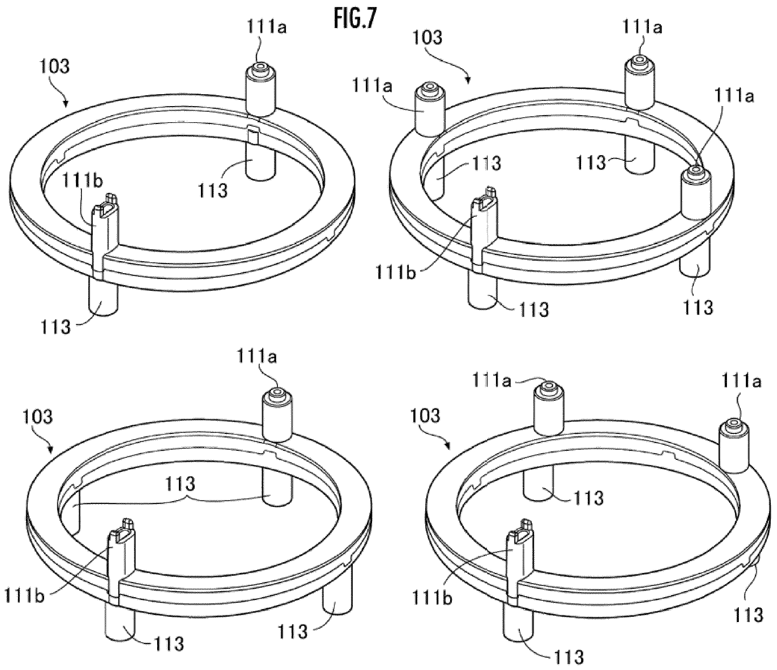

For example, FIG. 7 illustrates variations in the arrangement positions of the second protrusions 113.

In the upper left figure of FIG. 7, there are provided two first protrusions 111 (111a, 111b) and two second protrusions 113. In the upper right figure of FIG. 7, there are provided four first protrusions 111 (111a, 111b) and four second protrusions 113.

Alternatively, as illustrated in the lower left figure of FIG. 7, a different number of protrusions may be provided between the first protrusions 111 and the second protrusions 113, such as two first protrusions 111 (111a, 111b) and four second protrusion 113.

Alternatively, as illustrated in the lower right figure of FIG. 7, the first protrusion 111 and the second protrusion 113 may be provided at different positions.

In each figure, the first protrusion 111a without the element insertion part 131 and the plurality of second protrusions 113 are only illustrated as cylindrical. The present invention, however, is not limited thereto and the protrusions may have, for example, triangular, square, or other polygonal shapes.

Thus, the arrangement positions, quantity, and shape of the plurality of first protrusions 111 may be appropriately changed as long as the core housing case 103 is able to be fixed to the substrate 50.

In addition, the arrangement positions, quantity, and shape of the plurality of second protrusions 113 may be appropriately changed as long as the magnetic core 101 and the conductor 90 attached to the insertion hole 301 of the outer case 30 are able to be positioned orthogonally to each other.

### Description of the Reference Numerals

- 1: Current detector
- 10: Coil
- 101: Magnetic core
- 103: Core housing case
- 111: First protrusion
- 113: Second protrusion
- 105: Winding wire
- 30: Outer case
- 301: Insertion hole
- 303: Coil housing space
- 311: Inner wall surface
- 313: Movement restriction part
- 50: Substrate
- 501: Magnetic flux sensing element
- 90: Conductor
- Ga: Gap

## Claims

1. A magnetic balance type current detector with a ring-shaped coil fixed in an outer case, wherein:
the coil includes: a ring-shaped magnetic core that converges a magnetic flux generated by a current flowing through a conductor to be measured; a ring-shaped core housing case that houses the magnetic core; and a conductive winding wire that is wrapped around the core housing case to form the ring-shaped coil;
the outer case has an insertion hole formed inside, through which the conductor is inserted, and has a coil housing space that is a ring-shaped space that surrounds the insertion hole and houses the coil;
the current detector has a substrate with a magnetic flux sensing element mounted thereon, the magnetic flux sensing element sensing the magnetic flux converted on the magnetic core;
the core housing case being arranged between the substrate and an inner wall surface of the coil housing space of the outer case, and
the core housing case is provided with:
a first protrusion which is a protrusion protruding toward the substrate from an outer surface of the core housing case and fixing the core housing case to the substrate;
a second protrusion which is a plurality of protrusions that protrudes in an opposite direction of the first protrusion from the outer surface of the core housing case, abutting on the inner wall surface of the coil housing space to support the core housing case with respect to the outer case; wherein
a protrusion height of each of the plurality of second protrusions is a height which forms a gap between the inner wall surface and the coil, and positioning a ring formed by the magnetic core housed in the core housing case and the conductor attached to the insertion hole of the outer case orthogonally to each other, when an end portion of each of the plurality of second protrusions abuts on the inner wall surface of the coil housing space.

2. The current detector according to claim 1, wherein the outer case has a movement restriction part at a portion where the second protrusion abuts, so as to restrict a rotation of the coil around the conductor and a movement of the coil toward or away from the conductor.
